# EUROPEAN PATENT APPLICATION

(11) **EP 2 562 805 A1**
(43) Date of publication of application: **27.02.2013**
(21) Application number: 11771935.1
(22) Date of filing: 14.04.2011
(51) Int. Cl.: H01L 23/15

(54) **GLASS SUBSTRATE FOR SEMICONDUCTOR DEVICE VIA**

(30) Priority: 20.04.2010 JP 2010097225
(71) Applicant: Asahi Glass Company, Limited, Tokyo 100-8405 (JP)
(72) Inventor: KOIKE Akio, Tokyo 100-8405 (JP); ONO Motoshi, Tokyo 100-8405 (JP); MURAKAMI Ryota, Tokyo 100-8405 (JP); KIKUGAWA Shinya, Tokyo 100-8405 (JP)
(74) Representative: Müller-Boré & Partner Patentanwälte
(86) International application number: PCT/JP2011/059317
(87) International publication number: WO 2011/132600

(57) **Abstract**

A glass substrate for forming a through-substrate via of a semiconductor device is provided, in which the strength is improved compared to that of the conventional glass substrate. The glass substrate for forming the through-substrate via of the semiconductor device according to the present invention includes a first surface and a second surface, and penetration holes extending from the first surface to the second surface, and is characterized in that at least one of the first and second surfaces is chemically strengthened.

## Description

### TECHNICAL FIELD

The present invention relates to a glass substrate for forming a through-substrate via of a semiconductor device.

### BACKGROUND ART

In order to cope with demands to increase the integration density of the printed circuit board due to high-density packaging, a multi-layer printed circuit board was developed in which a plurality of printed circuit boards are stacked. In such a multi-layer printed circuit board, micro penetration holes having a diameter on the order of 100 µm or less, called via holes, are formed in a resin insulator layer and the inside of the penetration holes is plated in order to electrically connect conductor layers of the printed circuit boards that are stacked one on top of the other.

As a method of facilitating the forming of such penetration holes, Patent Documents No. 1 and No. 2 propose irradiating laser light on the insulator layer via a mask having a large number of penetration openings. According to this proposed method, a plurality of penetration holes may be formed simultaneously in the resin insulator layer, and thus, the penetration holes (via holes) may be formed with ease. In addition, a Non-Patent Document No. 1 proposes using for the insulator layer a glass substrate having a plurality of penetration holes.

On the other hand, due to increased demands to reduce the size, increase the operation speed, and reduce the power consumption of semiconductor devices, a three-dimensional SiP (System in Package) technology was developed in which the SiP technology that accommodates a system including a plurality of LSIs (Large Scale Integrated circuits) in a single package, and the three-dimensional packaging technology, are combined. In this case, the wire-bonding technology is unable to cope with the narrow pitch, and an interposing substrate called an interposer using through-substrate vias may be required. It may be conceivable to use a glass substrate as the interposing substrate.

### PRIOR ART DOCUMENTS

### PATENT DOCUMENTS

Patent Document 1: Japanese Laid-Open Patent Publication No. 2005-88045
Patent Document 2: Japanese Laid-Open Patent Publication No. 2002-126886

### NON-PATENT DOCUMENTS

Non-Patent Document 1: JPCA NEWS, p. 16 - p. 25, October 2009

### DISCLOSURE OF THE INVENTION

### PROBLEM TO BE SOLVED BY THE INVENTION

As described above, it is conceivable to use the glass substrate as the substrate material for forming the through-substrate via of the semiconductor device.

However, in such a glass substrate for forming the through-substrate via of the semiconductor device, there may be a problem in that a break or crack may easily occur in an outer peripheral part of an opening of a penetration hole (that is, at an interface of the penetration hole and a non-opening part) at the surface of the glass substrate. For example, there is a possibility that the crack may occur in the glass substrate for forming the through-substrate via of the semiconductor device even when a bending stress received thereby is small, from an origin formed by the outer peripheral part, and the glass substrate may break relatively easily.

Particularly due to the demands to further reduce the size of the semiconductor devices, the hole density of the penetration holes in the glass substrate for forming the through-substrate via of the semiconductor device is expected to increase further in the future. When such a tendency continues, the strength of the glass substrate may deteriorate further, and for this reason, the above described problem of the crack occurring at the outer peripheral part of the penetration hole may become more notable.

The present invention is conceived in view of the above problem, and one object of the present invention is to provide a glass substrate having a more satisfactory strength compared to the conventional glass substrate for forming the through-substrate via of the semiconductor device.

### MEANS OF SOLVING THE PROBLEM

The present invention may provide the following glass substrate for forming the through-substrate via of the semiconductor device.
(1) A glass substrate for forming a through-substrate via of a semiconductor device, including a first surface and a second surface, and penetration holes extending from the first surface to the second surface, characterized in that:
   at least one of the first and second surface is chemically strengthened.
(2) The glass substrate according to (1), characterized in that a thickness thereof is in a range of 0.01 mm to 5 mm.
(3) The glass substrate according to (1) or (2), characterized in that a thickness of a chemically strengthened layer at the chemically strengthened surface is in a range of 1 µm to 30 µm.
(4) The glass substrate according to any of (1) to (3), characterized in that a surface compressive stress thereof is 500 MPa or higher.
(5) The glass substrate according to any of (1) to (4), characterized in that a SiO₂ content thereof is in a range of 55 wt% to 75 wt%.
(6) The glass substrate according to any of (1) to (5), characterized in that a hole density of the penetration holes at the first surface is in a range of 0.1/mm² to 10,000/mm².
(7) The glass substrate according to any of (1) to (6), characterized in that the penetration holes have a tapered shape having a taper angle of 0.1° to 20°.

### EFFECTS OF THE INVENTION

The present invention may provide a glass substrate having a more satisfactory strength compared to the conventional glass substrate for forming the through-substrate via of the semiconductor device.

### BRIEF DESCRIPTION OF THE DRAWING

FIG. 1 is a diagram schematically illustrating a cross sectional view of a conventional glass substrate;
FIG. 2 is a diagram schematically illustrating an example of a cross sectional view of a glass substrate of the present invention;
FIG. 3 is a cross sectional view of another example of the glass substrate of the present invention on an enlarged scale;
FIG. 4 is a diagram schematically illustrating an example of a structure of a manufacturing apparatus used by a manufacturing method of the present invention;
FIG. 5 is a flow chart schematically illustrating the manufacturing method of the present invention; and
FIG. 6 is a top view schematically illustrating a structure of a mask 430 used in an embodiment.

### MODE OF CARRYING OUT THE INVENTION

A detailed description will hereinafter be given of the present invention with reference to the drawings.

In order to facilitate understanding of the features of the present invention, a simple description will first be given on a structure of a conventional glass substrate for forming a through-substrate via of a semiconductor device.

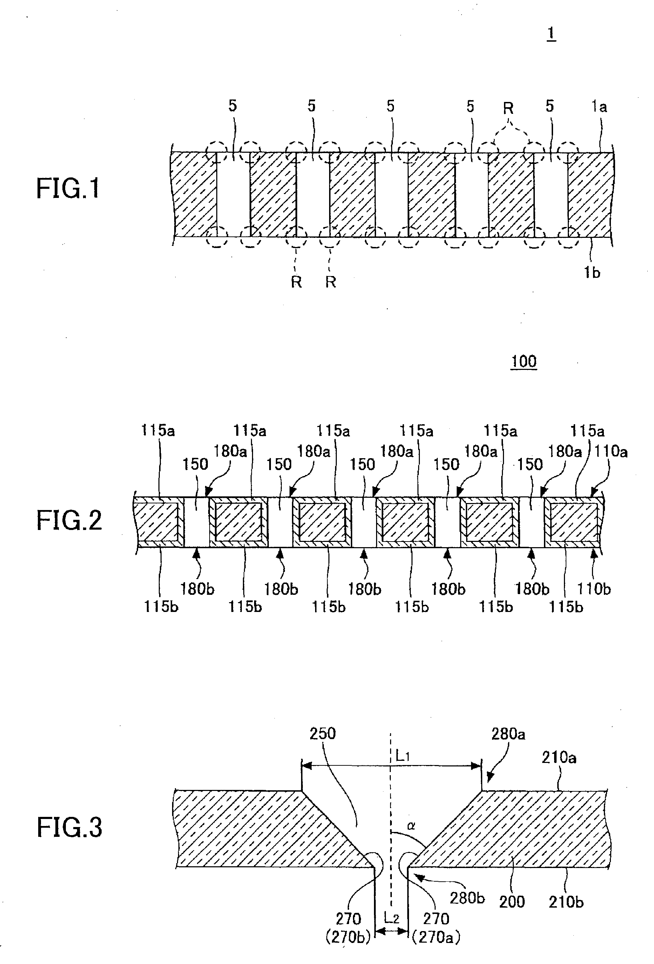

FIG. 1 is a diagram schematically illustrating a cross sectional view of the conventional glass substrate for forming the through-substrate via of the semiconductor device.

As illustrated in FIG. 1, a conventional glass substrate 1 for forming the through-substrate via of the semiconductor device includes a first surface 1a and a second surface 1b. In addition, the glass substrate 1 includes penetration holes 5. The penetration holes 5 penetrate the glass substrate 1 from the first surface 1a to the second surface 1b.

In a normal case, a conductive material is filled into the penetration holes 5, and for example, the conductive material may be used as electrodes of semiconductor devices or elements provided on or under the glass substrate 1. In addition, the glass substrate 1 may function as an insulator between the semiconductor devices.

Accordingly, the glass substrate 1 may be used as the substrate for forming the through-substrate via of the semiconductor device.

However, in the glass substrate 1 for forming the through-substrate via of the semiconductor device, there is a problem in that a break or crack may easily occur in an outer peripheral part of an opening of the penetration hole 5 (that is, at an interface of the penetration hole and a non-opening part: a part indicated by a circular symbol R in FIG. 1) at the surfaces 1a and 1b of the glass substrate 1. For example, the crack may occur in the glass substrate 1 for forming the through-substrate via of the semiconductor device even when a bending stress received thereby is small, from an origin formed by the outer peripheral part of the opening, and the glass substrate 1 may break relatively easily.

Particularly due to the demands to further reduce the size of the semiconductor devices, there is a tendency for the hole density of the penetration holes in the glass substrate for forming the through-substrate via of the semiconductor device to increase further. When such a tendency continues, the strength of the glass substrate may deteriorate further, and for this reason, the above described problem of the crack occurring at the outer peripheral part of the opening of the penetration hole may become more notable.

On the other hand, the glass substrate for forming the through-substrate via of the semiconductor device in accordance with the present invention (hereinafter simply referred to as "glass substrate of the present invention") is characterized by including a first surface and a second surface, and penetration holes extending from the first surface to the second surface, wherein at least one of the first and second surfaces is chemically strengthened.

In the present application, the term "chemically strengthened" is intended to have a generic meaning of the technology that applies a compressive stress on the surface of the glass substrate, by causing an alkali metal forming the surface of the glass substrate to make an ion exchange with another alkali metal that has a larger atomic number, at the surface of the glass substrate.

According to the glass substrate of the present invention having such features, the compressive stress is applied on the chemically strengthened surface, and thus, the strength at the outer peripheral part R of the opening of the penetration holes 5 improves compared to that of the conventional glass substrate. Hence, according to the present invention, the above described problem of the break and crack may be suppressed or reduced, and a glass substrate having a strength higher than that of the conventional glass substrate may be obtained.

Next, a more detailed description will be given of the structure of the glass substrate of the present invention, by referring to the drawings.

FIG. 2 is a diagram schematically illustrating an example of a cross sectional view of the glass substrate of the present invention.

As illustrated in FIG. 2, a glass substrate 100 of the present invention includes a first surface 110a and a second surface 110b. In addition, the glass substrate 100 includes penetration holes 150. The penetration hole 150 penetrates the glass substrate 100 from a first opening 180a provided in the first surface 110a to a second opening 180b provided in the second surface 110b.

In the glass substrate 100 of the present invention, the first surface 110a and/or the second surface 110b is/are characterized by having a chemically strengthened layer 115a and/or a chemically strengthened layer 115b formed by subjecting the glass substrate 100 to a chemical strengthening process.

Hence, the strength of the outer peripheral part (refer to part R in FIG. 1) of the openings 180a and 180b of the penetration hole 150 at the surface of the glass substrate 100 improves. Accordingly, in the present invention, the problem of the break or crack occurring at the outer peripheral part of the openings 180a and 180b of the penetration hole 150 due to a small stress load may significantly be suppressed.

For example, the thickness of the chemically strengthened layers 115a and 115b may be in a range of 1 µm to 30 µm, and preferably in a range of 5 µm to 25 µm, but is not limited to such ranges. The normal chemical strengthening process requires a deep chemically strengthened layer because a large surface compressive stress is applied, however, in the case of a thin plate-shaped glass substrate in which the plurality of penetration holes are formed as illustrated in FIG. 2, the entire glass may be subjected to the ion exchange when the chemical strengthening process is performed to the deep level. Because the surface compressive stress does not become large in this case, the chemically strengthened layers 115a and 115b are preferably not too deep. In addition, when the chemically strengthened layers 115a and 115b become too thick, an internal tensile stress becomes too large, and the brittleness of the glass substrate 100 may deteriorate. On the other hand, when the glass substrate 100 is too thin, it may not be possible to sufficiently obtain the effects of the chemical strengthening process.

In addition, in the glass substrate 100 of the present invention, a surface compressive stress at the chemically strengthened surface (110a and/or 110b) may preferably be 500 MPa or higher, and particularly preferably be 650 MPa or higher. In a case in which the surface compressive stress is lower than 500 MPa, it may not be possible to sufficiently obtain the effects of the chemical strengthening process.

The surface compressive stress of the glass substrate and the thickness of the chemically strengthened layer may easily be measured by a surface stress meter, such as the surface stress meter FSM-6000 manufactured by Orihara Manufacturing Co., LTD., for example.

The glass substrate 100 of the present invention, in a normal case, has a thickness in a range of 0.01 mm to 5 mm. When the thickness of the glass substrate exceeds 5 mm, it takes time to form the penetration hole, and on the other hand, when the thickness is less than 0.01 mm, a problem such as breaking may occur in the process. The thickness of the glass substrate 100 of the present invention is preferably 0.02 mm to 3 mm, and more preferably 0.02 mm to 1 mm. It is particularly preferable that the thickness of the glass substrate 100 of the present invention is greater than or equal to 0.05 mm and less than or equal to 0.4 mm.

The glass substrate 100 of the present invention includes 40 wt% of SiO₂ or more. The SiO₂ content may be in a range of 55 wt% to 75 wt%, for example. When the SiO₂ content exceeds this range, the possibility of generating cracks at the bottom surface of the glass substrate increases when forming the penetration hole. Other components are not particularly limited, and an arbitrary combination of arbitrary amounts of Al₂O₃, MgO, CaO, Na₂O, K₂O, ZrO₂, and the like may be used.

The glass substrate 100 of the present invention includes the plurality of penetration holes 150. Each penetration hole 150 may have a circular shape. In this case, the diameter of the penetration hole 150 may differ depending on the usage of the glass substrate 100 of the present invention, but generally, the diameter is preferably in a range of 5 µm to 500 µm. When the glass substrate 100 of the present invention is used as an insulator layer of a multi-layer circuit board described above, the diameter of the penetration hole is preferably 0.01 mm to 0.2 mm, and more preferably 0.02 mm to 0.1 mm. In addition, the WLP (Wafer Level Package) technology may be applied to stack the glass substrate 100 of the present invention on a wafer in order to form an IC chip used for a pressure sensor and the like. In this case, the diameter of the penetration holes 150 used as air inlets is preferably 0.1 mm to 0.5 mm, and more preferably 0.2 mm to 0.4 mm. Furthermore, in this case, the diameter of the penetration holes 150 used to draw out electrodes, other than the penetration holes 150 used as the air inlets, is preferably 0.01 mm to 0.2 mm, and more preferably 0.02 mm to 0.1 mm. Particularly when the glass substrate 100 of the present invention is used as the substrate for forming the through-substrate via, such as an interposer and the like, the diameter of the penetration holes 150 is preferably 0.005 mm to 0.075 mm, and more preferably 0.01 mm to 0.05 mm.

As will be described later, in the glass substrate 100 of the present invention, the diameter of the first opening 180a of the circular penetration hole 150 may be different from the diameter of the second opening 180b of this circular penetration hole 150. In this case, the "diameter of the penetration hole 150" refers to the larger one of the diameters of the two openings 180a and 180b.

A ratio (ds/dl) of the larger diameter (d1) and the smaller diameter (ds) is preferably 0.2 to 0.99, and more preferably 0.5 to 0.90.

The number density of the penetration holes 150 in the glass substrate 100 of the present invention may differ depending on the usage of the glass substrate 100 of the present invention, and may generally be in a range of 0.1/mm² to 10,000/mm². When the glass substrate 100 of the present invention is used as the insulator layer of the multi-layer circuit board described above, the number density of the penetration holes 150 is preferably in a range of 3/mm² to 10, 000/mm², and more preferably in a range of 25/mm² to 100/mm². In addition, when the glass substrate 100 of the present invention is stacked on the wafer by applying the WLP (Wafer Level Package) technology in order to form the IC chip used for the pressure sensor and the like, the number density of the penetration holes 150 is preferably in a range of 1/mm² to 25/mm², and more preferably in a range of 2/mm² to 10/mm². When the glass substrate 100 of the present invention is used as the substrate for forming the through-substrate via, such as the interposer and the like, the number density of the penetration holes 150 is preferably in a range of 0.1/mm² to 1,000/mm², and more preferably in a range of 0.5/mm² to 500/mm².

The absorption coefficient of the glass substrate 100 of the present invention with respect to the wavelength of the excimer laser light is preferably 3 cm⁻¹ or greater. In this case, the formation of the penetration holes 150 is further facilitated. In order to more effectively absorb the excimer laser light, the ion (Fe) content within the glass substrate 100 is preferably 20 mass ppm or higher, more preferably 0.01 mass% or higher, further more preferably 0.03 mass% or higher, and particularly preferably 0.05 mass% or higher. On the other hand, when the Fe content is high, the coloring may become stronger, and a problem may occur in which the alignment at the time of the laser beam machining becomes more difficult. The Fe content is preferably 0.2 mass% or lower, and more preferably 0.1 mass% or lower.

In the glass substrate of the present invention, the cross sectional area of the penetration hole may undergo a monotonic decrease from the first opening towards the second opening. This characterizing feature of the glass substrate will be described with reference to FIG. 3.

FIG. 3 is a cross sectional view of another example of the glass substrate of the present invention.

As illustrated in FIG. 3, a glass substrate 200 includes a first surface 210a and a second surface 210b. In addition, the glass substrate 200 includes a penetration hole 250. This penetration hole 250 penetrates the glass substrate 200 from a first opening 280a provided in the first surface 210a to a second opening 280b provided in the second surface 210b. It is to be noted that, in FIG. 3, the illustration of the chemically strengthened layer is omitted for clarity.

The penetration hole 250 has a diameter L1 at the first opening 280a, and has a diameter L2 at the second opening 280b.

Unlike the penetration hole 150 described above with reference to FIG. 2, the penetration hole 250 has a "taper angle" α. The taper angle α refers to the angle formed by a normal (indicated by a dotted line in FIG. 3) to the first surface 210a (and the second surface 210b) of the glass substrate 200 and a wall surface 270 of the penetration hole 250.

In FIG. 3, the angle formed by the normal to the glass substrate 200 and a right wall surface 270a of the penetration hole 250 is the taper angle α, but the angle formed by the normal to the glass substrate 200 and a left wall surface 270b is also the taper angle α in FIG. 3. Normally, the right taper angle α and the left taper angle α have values that are approximately the same.

In the glass substrate 200 of the present invention, the taper angle α is preferably in a range of 0.1° to 20°. In a case in which the penetration hole 250 of the glass substrate 200 has such a taper angle α, a wire may be quickly inserted into the inside of the penetration hole 250 from the side of the first surface 210a of the glass substrate 200 when performing a wire-bonding process. In addition, the conductive layers of the printed circuit boards stacked above and below the glass substrate 200 may easily be positively connected via the penetration holes 250 in the glass substrate 200. The taper angle α is particularly preferably in a range of 0.5° to 10°.

As will be described later, the taper angle α may be arbitrarily adjusted according to the method of manufacturing the glass substrate of the present invention.

In this specification, the taper angle α of the penetration hole in the glass substrate may be obtained in the following manner:
Obtain the diameter L1 of the penetration hole 250 at the opening 280a on the side of the first surface 210a of the glass substrate 200;
Obtain the diameter L2 of the penetration hole 250 at the opening 280b on the side of the second surface 210b of the glass substrate 200; and
Obtain the thickness of the glass substrate 200.

It is assumed that the taper angle α is uniform for all of the penetration holes 250, and the taper angle α is calculated from the above measurements.

The glass substrate of the present invention may be suitably used for semiconductor device parts, and more particularly for the insulator layer of the multi-layer circuit board, the WLP (Wafer Level Package), the penetration holes for drawing out the electrodes, the interposer, and the like.

### (Method of Manufacturing Glass Substrate of Present Invention)

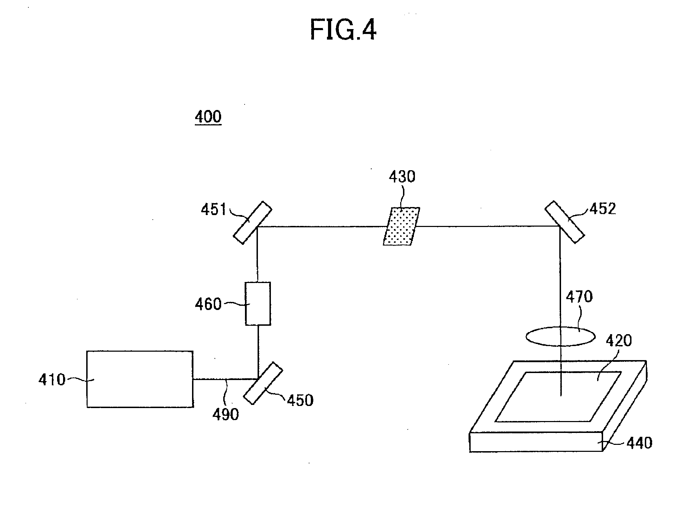

Next, a description will be given of the method of manufacturing the glass substrate of the present invention having the features described above, by referring to FIG. 4.

FIG. 4 is a diagram illustrating an example of a structure of a manufacturing apparatus used by the manufacturing method of the present invention.

As illustrated in FIG. 4, a manufacturing apparatus 400 includes an excimer laser light generating unit 410, a mask 430, and a stage 440. A plurality of mirrors 450 and 451 and a homogenizer 460 are arranged between the excimer laser light generating unit 410 and the mask 430. In addition, another mirror 452 and a projection lens 470 are arranged between the mask 430 and the stage 440.

For example, the mask 430 may be formed by a metal plate and the like having penetration openings. For example, materials such as chromium (Cr), stainless steel, and the like may be used for the metal plate.

Alternatively, the mask 430 may have a structure in which a pattern of a reflection layer is arranged on a base material (transparent base material) that is transparent with respect to the laser light, for example. Hence, in the mask 430, a part where the reflection layer is arranged on the transparent base material may block the laser light, and a part where no reflection layer is arranged on the transparent base material may transmit the laser light.

A glass substrate 420 that is a working target is arranged on the stage 440. The glass substrate 420 may be moved to an arbitrary position by moving the stage 440 two-dimensionally or three-dimensionally.

In the manufacturing apparatus 400 having the structure described above, excimer laser light 490 generated from the excimer laser light generating unit 410 is input to the mask 430 via the first mirror 450, the homogenizer 460, and the second mirror 451. The excimer laser light 490 is adjusted to laser light having a uniform intensity when the excimer laser light 490 passes through the homogenizer 460.

As described above, the mask 430 includes the pattern of the reflection layer on the base material that is transparent with respect to the laser light, for example. For this reason, the excimer laser light 490 is radiated from the mask 430 with a pattern corresponding to the pattern of the reflection layer (more particularly, the parts where no reflection layer is provided).

Thereafter, the direction of the laser light 490 transmitted through the mask 430 is adjusted by the third mirror 452, and is irradiated on the glass substrate 420 supported on the stage 440 through the reduction projection performed by the projection lens 470. The laser light 490 may simultaneously form a plurality of penetration holes in the glass substrate 420.

After the penetration holes are formed in the glass substrate 420, the glass substrate 420 may be moved on the stage 440 before the excimer laser light 490 is again irradiated on the glass substrate 420. Hence, the desired penetration holes may be formed at desired parts on the surface of the glass substrate 420. In other words, the known step-and-repeat method may be applied to this method.

The projection lens 470 preferably irradiates the excimer laser light 490 on the entire work region on the surface of the glass substrate 420 in order to simultaneously form the plurality of penetration holes. Normally, however, it may be difficult to obtain an irradiation fluence capable of simultaneously forming all of the penetration holes. Hence, the excimer laser light 490 transmitted through the mask 430 is actually subjected to the reduction projection performed by the projection lens 470, in order to increase the irradiation fluence of the excimer laser light 490 at the surface of the glass substrate 420, and to secure the irradiation fluence required to form the penetration holes.

By utilizing the reduction projection performed by the projection lens 470, the irradiation fluence may be increased to 10 times when the cross sectional area of the excimer laser light 490 at the surface of the glass substrate 420 is 1/10 the cross sectional area of the excimer laser light 490 immediately after being transmitted through the mask 430. By using a projection lens having a reduction ratio of 1/10 and setting the cross sectional area of the excimer laser light at the substrate surface to 1/100, the irradiation fluence of the excimer laser light at the surface of the glass substrate 420 may be made 100 times that of the excimer laser light immediately after being generated from the excimer laser light generating unit 410.

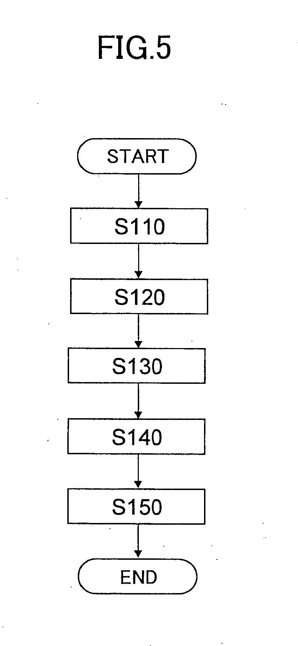

FIG. 5 is a flow chart schematically illustrating an example of the manufacturing method for the glass substrate of the present invention.

As illustrated in FIG. 5, the manufacturing method for the glass substrate of the present invention includes
(1) A step (step S110) to prepare a glass substrate;
(2) A step (step S120) to arrange the glass substrate in an optical path of an excimer laser light from an excimer laser light generating unit;
(3) A step (step S130) to arrange a mask in the optical path between the excimer laser light generating unit and the glass substrate;
(4) A step (step S140) to irradiate excimer laser light from the excimer laser light along the optical path onto the glass substrate, in order to form penetration holes in the glass substrate; and
(5) A step (step S150) to perform a chemical strengthening process on the obtained glass substrate having the penetration holes.

Next, a description will be given of each of the above steps.

### (Step S110)

First, the glass substrate is prepared. The preferable composition and the like of the glass substrate are as described above. Preferably, the glass substrate includes 40 wt% of SiO₂ or more, and has a glass transition temperature in a range of 400°C to 700°C. Further, preferably, the glass substrate has an average coefficient of thermal expansion in a range of 20 x 10⁻⁷/K to 100 x 10⁻⁷/K at 50°C to 350°C.

### (Step S120)

Next, the glass substrate is arranged in the optical path of the excimer laser light from the excimer laser light generating unit. As illustrated in FIG. 4, the glass substrate 420 may be arranged on the stage 440.

The excimer laser light 490 generated from the excimer laser light generating unit 410 may have an oscillation wavelength of 250 nm or less. From the point of view of the output, KrF excimer laser (wavelength of 248 nm), ArF excimer laser (193 nm), or F₂ excimer laser (wavelength of 157 nm) may preferably be used. From the point of view of the handling ease and the absorption of glass, the ArF excimer laser is more preferable.

In addition, when the excimer laser light 490 that is used has a narrow pulse width, the thermal diffusion distance at the irradiated part on the glass substrate 420 becomes short, and the effect of the heat with respect to the glass substrate may be suppressed. From this point of view, the pulse width of the excimer laser light 490 is preferably 100 nsec or less, more preferably 50 nsec or less, and particularly preferably 30 nsec or less.

Moreover, the irradiation fluence of the excimer laser light 490 is preferably 1 J/cm² or higher, and more preferably 2 J/cm² or higher. When the irradiation fluence of the excimer laser light 490 is too low, it may not be possible to induce aberration, and the forming of the penetration holes in the glass substrate may become difficult. On the other hand, when the irradiation fluence of the excimer laser light 490 exceeds 20 J/cm², there is a tendency for the cracks and breaks to be more easily generated in the glass substrate. A preferable range of the irradiation fluence of the excimer laser light 490 may differ depending on the wavelength region of the excimer laser light 490 used, the type of glass substrate that is the working target, and the like, and may preferably be 2 J/cm² to 20 J/cm² in a case of the KrF excimer laser (wavelength of 248 nm). In addition, the preferable range of the irradiation fluence of the excimer laser light 490 may be 1 J/cm² to 15 J/cm² in a case of the ArF excimer laser (wavelength of 193 nm).

Unless specifically described, the value of the irradiation fluence of the excimer laser light 490 refers to the value at the surface of the glass substrate that is the working target. In addition, the value of such an irradiation fluence refers to the value that is measured on a working surface using an energy meter.

### (Step S130)

Next, the mask 430 is arranged between the excimer laser light generating unit 410 and the glass substrate 420.

As described above, the mask 430 may be formed by the metal plate and the like having the penetration holes. The material forming the metal plate may be chromium (Cr), stainless steel, and the like.

Alternatively, the mask 430 may have a structure in which the pattern of the reflection layer is formed on the transparent base material. The material forming the transparent base material is not limited to a particular material as long as the material is transparent with respect to the laser light 490. For example, the material forming the transparent base material may be synthetic silica, fused silica, Pyrex (registered trademark), soda-lime glass, no-alkali glass, borosilicate glass, and the like.

On the other hand, the material forming the reflection layer is not limited to a particular material as long as the material has properties to efficiently block the laser light 490. For example, the material forming the reflection layer may be a metal such as chromium, silver, aluminum, and/or gold.

In addition, the size of the mask 430, and the shape, the arrangement and the like of the pattern of the reflection layer of the mask 430 are not particularly limited.

### (Step S140)

Next, the excimer laser light 490 from the excimer laser light generating unit 410 is irradiated on the glass substrate 420 via the mask 430.

When irradiating the excimer laser light 490 on the glass substrate 420, the repetition frequency and the irradiation time of the excimer laser light may be adjusted, in order to adjust the number of shots ([number of shots] = [repetition frequency] x [irradiation time]).

The excimer laser light 490 is preferably irradiated on the glass substrate 420 so that the a product of the irradiation fluence (J/cm²) and the number of shots (times) and the thickness (mm) of the glass substrate becomes in a range of 1,000 to 30,000.

This range may depend on the type of the glass substrate 420 and its characteristics (particularly assumed to be related to a glass transition temperature Tg), but in general, is preferably 1,000 to 20,000, more preferably 2,000 to 15,000, and particularly preferably 3,000 to 10,000. When the product of the irradiation fluence and the number of shots is within such ranges, the cracks are uneasily formed in the glass substrate. The irradiation fluence is preferably 1 J/cm² to 20 J/cm².

In addition, the taper angle α has a tendency to become small when the irradiation fluence of the excimer laser light is large. On the other hand, the taper angle α has a tendency to become large when the irradiation fluence of the excimer laser light is small. Hence, the glass substrate having the penetration holes with the desired taper angle α may be obtained, by adjusting the irradiation fluence. The taper angle α may be in a range of 0.1° to 20°.

Normally, the wafer size used for manufacturing a semiconductor circuit is on the order of 6 inches to 8 inches. In addition, in the case in which the reduction projection is performed by the projection lens 470 as described above, the work region at the surface of the glass substrate normally becomes a square having a side on the order of several mm. Accordingly, in order to irradiate the excimer laser light on the entire region of the glass substrate 420, that is the work target, the excimer laser light needs to be moved, or the glass substrate 420 needs to be moved. Preferably, the glass substrate 420 is moved with respect to the excimer laser light, because it is unnecessary to drive an optical system in this case.

In addition, debris (scattered particles) may be generated when the excimer laser light is irradiated on the glass substrate 420. When the debris accumulate within the penetration hole, the quality of the worked glass substrate and the working rate of the glass substrate may deteriorate. Hence, a suction or blow process may be performed simultaneously as the laser irradiation on the glass substrate, in order to remove the debris.

### (Step S150)

Next, a chemical strengthening process is performed on the obtained glass substrate having the penetration holes.

The conditions of the chemical strengthening process is not particularly limited. For example, the chemical strengthening process may be performed by dipping the glass substrate into fused salt that includes potassium salt, such as potassium nitrate (KNO₃), nitrate having potassium nitrate (KNO₃) as the main component, or the like. In this case, sodium (Na) and/or lithium (Li) at the surface of the glass substrate makes an ion exchange with potassium (K), to thereby enable the chemical strengthening of the surface of the glass substrate.

In addition, the processing temperature and the processing time are not particularly limited. For example, when using the fused salt of potassium nitrate (KNO₃), the processing temperature may be in a range of 350°C to 500°C. In addition, the processing time may be in a range of 1 hour to 12 hours. In order to form a surface compressive layer of 500 MPa or higher and having a chemically strengthened layer in a range of 1 µm to 30 µm, it may be preferable that the processing temperature is set relatively low in a range of 400°C to 450°C and the processing time is set relatively short in a range of 1 hour to 4 hours.

The glass substrate of the present invention for forming the through-substrate via of the semiconductor device may be manufactured by the steps described above.

### Embodiments

Next, a description will be given of embodiments of the present invention.

### (Example 1)

The glass substrate having the plurality of penetration holes is manufactured according to the following procedures, using the manufacturing apparatus illustrated in FIG. 4.

### (Manufacturing Glass Substrate)

First, a plate-shaped glass is formed according to the following procedures.

Each raw material powder is weighed and mixed in order to obtain 1 kg of a mixed powder that includes 72.8 wt% of SiO₂, 1.9 wt% of Al₂O₃, 3.7 wt% of MgO, 8.1 wt% of CaO, 13.1 wt% of Na₂O, and 0.3 wt% of K₂O. In addition, sodium sulfate is added to become 0.4 wt% in SO₃-equivalent-content. Next, the mixed powder is put into a platinum crucible and maintained at 1600°C for 3 hours, in order to melt the mixed powder. The melted material is subjected to a degassing process and homogenized, before flowing the melted material into a mold. Thereafter the mold is slowly cooled, in order to obtain a glass sample.

The glass sample that is obtained is cut and polished into a size having a vertical length of 100 mm x horizontal length of 100 mm x thickness of 0.3 mm. Further, a mirror finish polishing process is performed on the glass sample, in order to obtain a glass substrate that is a work target.

The density and the Young's modulus of the glass substrate are 2.49 g/cm³ and approximately 73 GPa, respectively. In addition, the average coefficient of thermal expansion of the glass substrate is 88 x 10⁻⁷/K at 50°C to 350°C. In addition, the glass transition temperature and the strain point of the glass substrate are 540°C and 528°C, respectively.

The density is measured by the Archimedian method, the Young's modulus is measured by the resonance method, and the glass transition temperature and the average coefficient of thermal expansion at 50°C to 350°C are measured by a differential thermal expansion analyzer (TMA), and the strain point is measured by the fiber elongation method based on JIS-R3103.

Table 1 illustrates the composition, density, Young's modulus, average coefficient of thermal expansion, glass transition temperature, and strain point of the glass substrate used in a row of the "Example 1".

**[Table 1]**

| Examples | Glass Composition | | | | | | | Evaluation Results | | | | |
|---|---|---|---|---|---|---|---|---|---|---|---|---|
| | SO₂ | Al₂O₃ | MgO | CaO | Na₂O | K₂O | ZrO₂ | Density (g/cm³) | Young's Modulus (GPa) | Average Coefficient of Thermal Expansion (10⁻⁷/K) | Glass Transition Temperature (°C) | Strain Point (°C) |
| Example 1 | 728 | 1.9 | 3.7 | 8.1 | 13.1 | 0.3 | - | 249 | 73 | 88 | 540 | 528 |
| Example 2 | 60.9 | 9.6 | 7.0 | - | 11.7 | 5.9 | 4.8 | 252 | 78 | 91 | 620 | 578 |
| Example 3 | 62.2 | 17.2 | 3.9 | 0.6 | 12.8 | 3.5 | - | 2.46 | 73 | 93 | 595 | 553 |

Next, the excimer laser light generating unit 410 is arranged as illustrated in FIG. 4. The LPX Pro 305 (Coherent, Inc.) is used as the excimer laser light generating unit 410. This generating unit may generate ArF excimer laser light having a maximum pulse energy of 0.6 J, a repetition frequency of 50 Hz, a pulse width of 25 ns, a beam size of 10 mm x 24 mm at the time of the generation, and an oscillation wavelength of 193 nm.

Next, the glass substrate 420 that is formed by the method described above is arranged on the stage 440.

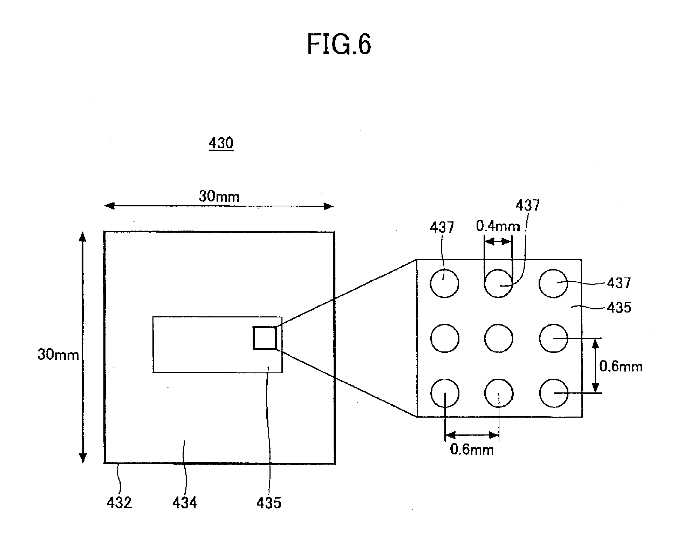

Next, the mask 530 is arranged between the excimer laser light generating unit 410 and the glass substrate 420. FIG. 6 schematically illustrates the structure of the mask 430 that is used.

As illustrated in FIG. 6, the mask 430 used has a penetration opening array part 435 in a part of a first surface 434 of a stainless steel substrate 432 with a size having vertical length of 30 mm x horizontal length of 30 mm x thickness of 0.5 mm. The penetration opening array part 435 is arranged approximately in a central region of the first surface 434 of the stainless steel substrate 432.

As illustrated on the right side in FIG. 6, the penetration opening array part 435 includes circular penetration openings 437 having a diameter of 0.4 mm that are arranged in the vertical and horizontal directions in a pattern of a two-dimensional array. The penetration openings 437 are arranged at a pitch of 0.6 mm in both the vertical and horizontal directions, and 16 penetration openings are arranged in the vertical direction and 40 penetration openings are arranged in the horizontal direction.

The penetration openings 437 may transmits the ArF excimer laser light. On the other hand, other regions of the mask 430 reflect the ArF excimer laser light.

Next, the projection lens 470 is arranged between the mask 430 and the glass substrate 420. The projection lens 470 has a focal distance of 100 mm, and is arranged so that the distance from the mask 430 along the optical path is 1100 mm, and the distance from the working surface of the glass substrate 420 (the surface not in contact with the stage 440) is 110 mm. In this case, a reduction ratio of the projection lens 470 becomes 1/10, and a mask pattern that is reduced to 1/10 is projected onto the glass substrate 420. In other words, the excimer laser light 490 that is generated from the excimer laser light generating unit 410 with a beam size of 10 mm x 24 mm is reduced to a beam size of 1.0 mm x 2.4 mm at a time when the excimer laser light reaches the working surface of the glass substrate 420 (area ratio = 1/100).

Before the laser beam machining is performed on the glass substrate 420, the irradiation fluence of the excimer laser light 490 at the working surface of the glass substrate 420 is measured by the energy meter. As a result of the measurement, the irradiation fluence is on the order of 11 J/cm² at the maximum, including a decrease caused by a loss of a beam transmission system and the like and an improvement caused by the beam reduction.

The manufacturing apparatus described is used to irradiate the excimer laser light 490 on the working surface of the glass substrate 420. When irradiating the excimer laser light 490, the excimer laser light 190 is adjusted by an attenuator so that the irradiation fluence at the working surface of the glass substrate 420 becomes 7 J/cm². By the irradiation of the laser light 490, the penetration openings are simultaneously formed at 16 x 40 = 640 locations in the glass substrate 420.

Next, the stage is moved by a predetermined amount, and an operation similar to that described above is repeated every time the stage is moved. Hence, a large number of penetration holes are formed in the glass substrate, in a central region with a size having a vertical length of 9.6 mm x horizontal length of 9.6 mm. The density of the penetration holes is 289/cm².

From an external appearance, no cracks are detected in the worked glass substrate.

Next, the chemical strengthening process is performed on both the first surface and the second surface of the glass substrate that is obtained. The chemical strengthening process is performed by dipping the glass substrate in the potassium nitrate solution in atmosphere at 400°C for 480 minutes.

The glass substrate of the Example 1 is obtained in the above described manner.

### (Evaluation of Glass Substrate)

Next, the thickness of the chemically strengthened layer is measured for the glass substrate that is obtained. The surface stress meter FSM-6000 manufactured by Orihara Manufacturing Co., LTD. is used for the measurement. As a result of the measurement, the thicknesses of the chemically strengthened layers formed on both surfaces of the glass substrate respectively are approximately 10 µm.

In addition, the surface compressive stress is measured for the glass substrate that is obtained. The surface stress meter FSM-6000 manufactured by Orihara Manufacturing Co., LTD. is used for the measurement.

As a result of the measurement, the surface compressive stress at both surfaces of the glass substrate is approximately 660 MPa.

Table 2 illustrates the thickness of the chemically strengthened layer and the surface compressive stress of the glass substrate of the Example 1 in the row of the "Example 1".

**[Table 2]**

| Examples | Evaluation Results | |
|---|---|---|
| | Thickness of Chemically Strengthened Layer (*µ*m) | Surface Compressive Stress (MPa) |
| Example 1 | 10 | 660 |
| Example 2 | 15 | 850 |
| Example 3 | 20 | 750 |

Accordingly, in the glass substrate of the Example 1, it is possible to obtain the chemically strengthened layer having a thickness of approximately 10 µm, and thus, the glass substrate having the surface compressive stress of 500 MPa or higher may be obtained. In the glass substrate having such a high surface compressive stress, it may be regarded that the generation of the breaks and cracks are significantly suppressed, even when used as the glass substrate for forming the through-substrate via of the semiconductor device.

### (Example 2)

A glass substrate having a large number of penetration holes is formed by a method similar to that for the Example 1, and the chemical strengthening process is performed on the glass substrate.

However, in an Example 2, the composition of the plate-shaped glass is 60.9 wt% of SiO₂, 9.6 wt% of Al₂O₃, 7.0 wt% of MgO, 11.7 wt% of Na₂O, 5.9 wt% of K₂O, and 4.8 wt% of ZrO₂. No Cao is added. Other manufacturing conditions of the plate-shaped glass are similar to those of the Example 1.

The Table 1 illustrates the composition and various characteristics of the glass substrate in a row of the "Example 2". The density is 2.52 g/cm³ and the Young's modulus is approximately 78 GPa for the glass substrate that is obtained. In addition, the average coefficient of thermal expansion of the glass substrate is 91 x 10⁻⁷/K at 50°C to 350°C. Further, the glass transition temperature is 620°C, and the strain point is 578°C.

Moreover, the conditions of the laser beam machining and the conditions of the chemical strengthening process with respect to the glass substrate are similar to those of the Example 1. However, in the Example 2, the time of the chemical strengthening process (time for which the glass substrate is dipped into the KNO₃ solution) is 90 minutes.

The thickness of the chemically strengthened layer and the surface compressive stress of the glass substrate of the Example 2 are measured. The measured results are illustrated in a row of the "Example 2".

The thickness of the chemically strengthened layer on both surfaces of the glass substrate is 15 µm. In addition, the surface compressive stress of the glass substrate that is obtained is approximately 850 MPa at both surfaces thereof.

In the glass substrate having such a high surface compressive stress, it may be regarded that the generation of the breaks and cracks are significantly suppressed, even when used as the glass substrate for forming the through-substrate via of the semiconductor device.

### (Example 3)

A glass substrate having a large number of penetration holes is formed by a method similar to that for the Example 1, and the chemical strengthening process is performed on the glass substrate.

However, in an Example 3, the composition of the plate-shaped glass is 62.2 wt% of SiO₂, 17.2 wt% of Al₂O₃, 3.9 wt% of MgO, 0.6 wt% of CaO, 12.8 wt% of Na₂O, and 3.5 wt% of K₂O. No ZrO₂ is added. Other manufacturing conditions of the plate-shaped glass are similar to those of the Example 1.

The Table 1 illustrates the composition and various characteristics of the glass substrate in a row of the "Example 3". The density is 2.46 g/cm³ and the Young's modulus is approximately 73 GPa for the glass substrate that is obtained. In addition, the average coefficient of thermal expansion of the glass substrate is 93 x 10⁻⁷/K at 50°C to 350°C. Further, the glass transition temperature is 595°C, and the strain point is 553°C.

Moreover, the conditions of the laser beam machining and the conditions of the chemical strengthening process with respect to the glass substrate are similar to those of the Example 1. However, in the Example 3, the time of the chemical strengthening process (time for which the glass substrate is dipped into the KNO₃ solution) is 120 minutes.

The thickness of the chemically strengthened layer and the surface compressive stress of the glass substrate of the Example 3 are measured. The measured results are illustrated in a row of the "Example 3".

The thickness of the chemically strengthened layer on both surfaces of the glass substrate is 20 µm. In addition, the surface compressive stress of the glass substrate that is obtained is approximately 750 MPa at both surfaces thereof.

In the glass substrate having such a high surface compressive stress, it may be regarded that the generation of the breaks and cracks are significantly suppressed, even when used as the glass substrate for forming the through-substrate via of the semiconductor device.

The present invention is described above in detail with reference to specific embodiments, however, it may be apparent to those skilled in the art that various variations and modifications may be made without departing from the spirit and scope of the present invention.

This application is based on a Japanese Patent Application No. 2010-097225 filed on April 20, 2010, the disclosure of which is hereby incorporated by reference.

### INDUSTRIAL APPLICABILITY

The present invention may be applied to glass substrates preferably usable for parts of semiconductor devices, more particularly, insulator layers of multi-layer circuit boards, wafer level packages, penetration holes for drawing out electrodes, interposers, and the like.

### DESCRIPTION OF REFERENCE NUMERALS

- 1: Conventional Glass Substrate
- 1a: First Surface
- 1b: Second Surface
- 5: Penetration Hole
- 100: Glass Substrate of Present Invention
- 110a: First surface
- 110b: Second Surface
- 115a, 115b: Chemical Strengthening Layer
- 150: Penetration Hole
- 180a: First Opening
- 180b: Second Opening
- 200: Other Glass Substrate
- 210a: First Surface
- 210b: Second Surface
- 250: Penetration Hole
- 270: Wall Surface of Penetration Hole
- 280a: First Opening
- 280b: Second Opening
- α: Taper Angle
- L1: Diameter of First Opening of Penetration Hole
- L2: Diameter of Second Opening of Penetration Hole
- 400: Manufacturing Apparatus
- 410: Excimer Laser Light Generating Unit
- 420: Glass Substrate
- 430: Mask
- 432: Stainless Steel Substrate
- 434: First Surface
- 435: Penetration Opening Array Part
- 437: Penetration Opening
- 440: Stage
- 450 - 452: Mirror
- 460: Homogenizer
- 470: Projection Lens
- 490: Excimer Laser Light

## Claims

1. A glass substrate for forming a through-substrate via of a semiconductor device, including a first surface and a second surface, and penetration holes extending from the first surface to the second surface, **characterized in that**:
at least one of the first and second surface is chemically strengthened.

2. The glass substrate as claimed in claim 1, **characterized in that** a thickness thereof is in a range of 0.01 mm to 5 mm.

3. The glass substrate as claimed in claim 1 or 2, **characterized in that** a thickness of a chemically strengthened layer at the chemically strengthened surface is in a range of 1 µm to 30 µm.

4. The glass substrate as claimed in any of claims 1 to 3, **characterized in that** a surface compressive stress thereof is 500 MPa or higher.

5. The glass substrate as claimed in any of claims 1 to 4, **characterized in that** a SiO₂ content thereof is in a range of 55 wt% to 75 wt%.

6. The glass substrate as claimed in any of claims 1 to 5, **characterized in that** a hole density of the penetration holes at the first surface is in a range of 0.1/mm² to 10, 000/mm².

7. The glass substrate as claimed in any of claims 1 to 6, **characterized in that** the penetration holes have a tapered shape having a taper angle of 0.1° to 20°.
